# EUROPEAN PATENT APPLICATION

(11) **EP 1 499 025 A1**
(43) Date of publication of application: **19.01.2005**
(21) Application number: 03291767.6
(22) Date of filing: 17.07.2003
(51) Int. Cl.: H03M 13/29, H03M 13/37

(54) **Stop criterion for an iterative data processing method**

(71) Applicant: Evolium S.A.S., 75008 Paris (FR)
(72) Inventor: Buné, Paul A. M., 70806 Kornwestheim (DE)
(74) Representative: Richardt, Markus Albert

(57) **Abstract**

The present invention relates to a data processing method of transforming an input data set having a number of data bits to an output data set having the same number of data bits by means of a data processing module, the data processing module being adapted to transform a first data set containing the number of data bits to a second data set containing the number of data bits in one data processing iteration, the data processing method comprising the steps of:
- entering the input data set as a first data set into the data processing module,
- performing a data processing iteration by means of the data processing module to provide the second data set,
- outputting the second data set as the output data set if the first and second data sets of the same data processing iteration are identical, and otherwise entering the second data set as a first data set for a consecutive data processing iteration.

## Description

### Field of the invention.

The present invention generally relates to the field of data processing, and more particularly without limitation, to Turbo decoding, in particular for the purposes of cellular mobile communication.

### Background and prior art

Turbo code was introduced in 1993 (C Berrou, A Glavieux, and P. Thitimajshima, "Near Shannon limit error-correcting coding and decoding: Turbo codes", in IEEE Int. Conf. on Communications, pp. 1064-1070, 1993) and has become one of the important topics in communication and coding societies since its performance is close to the theoretical limit. As far as applications of turbo codes are concerned, it has been decided that turbo codes are to be used in 3rd generation W-CDMA systems.

Among various variables the word lengths of data inputs (soft inputs) and the extrinsic information are especially important. Turbo decoders inherently have long interleavers between two constituent decoders, and the amount of memories required to store data inputs and the extrinsic information depends on the interleaver length and the word lengths of these two variables.

Power consumption is another concern in portable wireless applications. When decoders operate at high signal to noise ratios (SNRs) , many iterations are not required to attain the target bit error ratio (BER), and it is possible to stop the operation after a few iterations resulting in low power consumption. Several stop criteria have been proposed in the prior art : A. G Burr, "Turbo-codes: the ultimate error control codes?", IEE Electronics and Communications Engineering Journal, Vol. 13, No. 4, pp. 155-165, August 2001; Schurgers, C., van der Perre, L., Engels, M., and de Man, H,:"Adaptive turbo decoding for indoor wireless communication", Proc. ISSSE'98, 1998 URSI Int. Symposium on Signals, Systems and Electronics, pp. 107-111 J. Yi S.Hong and W. E. Stark, "VLSI Design and Implementaion of Low-Complexity Adaptive TURBO-code Encoder and Decoder for Wireless Mobile Communication Applications", IEEE Workshop on Signal Processing Systems, Design and Implementation, 1998, P. Robertson, "Illuminating the structure of code and decoder of parallel concatenated recursive systematic (turbo) codes", in Globcom Conference pp. 1298-1303, 1994; E. Offer J. Hagenauer and L. Papke, "Iterative decoding of binary block and convolutional codes", IEEE Trans. On Information Theory, pp. 429-445.).

Turbo decoders consist of two recursive systematic convolutional (RSC) encoders and a random interleaver between them. Turbo decoders contain two SISO (Soft Input Soft Output) decoders which are associated with two RSC encoders, and an interleaver between those two decoders. The SISO decoders generate soft outputs which represent how reliable the outputs are. Either maximum a posteriori (MAP) algorithm or soft output Viterbi algorithm (SOVA) can be used for the constituent decoders.

One prior art approach to provide a stop criterion is to perform the turbo decoding with a fixed number of iterations. The number of iterations must be chosen such that a given long-term decoding performance requirement is satisfied. Especially in case of dynamic channels which are typical for mobile radio, this means that frames received with a high signal to interference ratio, which need only few iterations for error-free decoding, are processed with the same high number of iterations needed for frames with low SIR. This implies that many iterations are 'waisted' as they are performed on signals that are already error-free. This way up to 70% or more unnecessary iterations are performed under typical circumstances.

An alternative prior art approach is convergence detection based on sophisticated iteration-internal metric evaluation and its comparison with a given threshold. This approach is disadvantageous due to its complexity regarding the choice, implementation and performance of the metric evaluation. A further disadvantage is that the threshold has to be determined carefully by simulations. If the threshold for the stop criterion is too high, still many iterations are waisted, if it is too low, decoding performance is degraded.

Similar problems exist with respect to other iterative data processing operations, such as iterative channel estimation to provide an impulse response estimation of a channel and other iterative data processing and digital signal processing methods.

### Summary of the invention

The present invention provides for a data processing method for performing data processing iterations in order to transform an input data set to an output data set. The input data set is transformed to a second data set having the same number of data bits as the input data set by means of a first data processing iteration. The second data set is used as a first data set for a consecutive data processing iteration which provides a new second data set, etc. The first and second data sets are stored separately, i.e. the first data set is not overwritten by the second data set when the transformed data bits are sequentially outputted. Between iterations the first and second data sets are compared in order to determine whether there is at least one deviant bit in the first and second data sets. When the first and second data sets are found to be identical this means that a stop criterion is met and that the iterative processing stops.

In accordance with a preferred embodiment of the invention the comparison of the first and second data sets of one data processing iteration is performed sequentially. This has the advantage, that the comparison process can stop when a first deviant bit in the respective data bit sequences has been detected.

In accordance with a preferred embodiment of the invention a turbo decoding processing step is performed in each iteration. In this instance the so-called hard-bits or systematic bits are compared after each iteration in order to test the stop criterion. When the stop criterion is met the systematic output bits are forwarded to the next module in a receiver, such as a base station of a cellular mobile digital communication network.

It is a particular advantage of the present invention that an iterative decoding procedure is performed with improved efficiency avoiding unnecessary iterations without decoding performance degradation. It is a further advantage of the present invention that its implementation is easy to implement and does not require threshold tuning. Further existing iterative processing modules, such as existing turbo decoder iteration algorithms, can be reused without a need to change. It is another advantage of the present invention that it does not include or need cyclic redundancy check (CRC) evaluation.

It is to be noted that the present invention is not limited to turbo decoding or other decoding algorithms but that it can be applied to other fields of data processing, such as for iterative channel estimation for estimation of an impulse response of a transmission channel.

### Brief description of the drawings

In the following preferred embodiments of the invention will be described in greater detail by making reference to the drawings in which:
- Figure 1: is a block diagram of a data processing system,
- Figure 2: is illustrative of a flow chart for operating of the data processing system of figure 1,
- Figure 3: is illustrative of the sequential comparison of the input and output data sets of one data processing iteration,
- Figure 4: is a block diagram of a turbo decoder,
- Figure 5: is illustrative of a flow chart showing the operation of the turbo decoder of figure 4.

### Detailed description

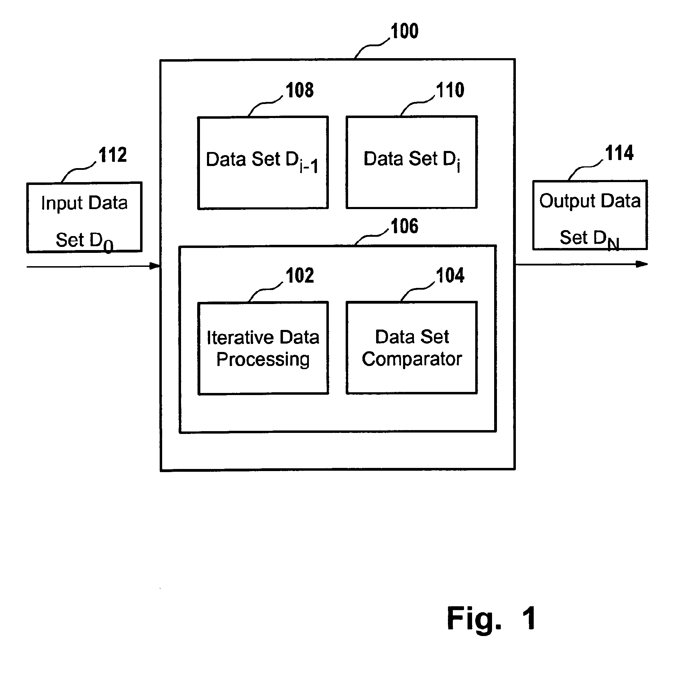

Figure 1 shows a data processing system 100 having a program module 102 and a program module 104 which run on processor 106. When program module 102 is invoked it performs a sequence of data processing iterations. Program module 104 serves to compare two data sets having the same number of data bits.

Data processing system 100 has memory area 108 for storing of a complete data set and memory area 110 for storing of another complete data set.

In operation an input data set D₀ 112 is entered into data processing system 100. Input data set D₀ has a number of M data bits. For example input data set is a sequence of M data bits.

Input data set D₀ is entered into program module 102 and into memory area 108 in order to preserve the original input data set D₀ .

The result of the data processing iteration performed by program module 102 is a transformation of the input data set D₀ to data set D₁ which is stored in memory area 110. After completion of the first iteration program module 104 compares data set D₀ stored in memory 108 and data set D₁ stored in memory area 110.

When the data sets D₀ and D₁ are identical this means that the stop criterion for the iteration is met; otherwise the consecutive iteration is performed by program module 102 using the output data of the previous iteration, i.e. data set D₁, as input data for the consecutive iteration. After a number of N iterations, program module 104 may determine that the data sets Dᵢ₋₁ and Dᵢ are identical such that the iterative data processing is stopped and the data set D_{N} is outputted as output data set 114.

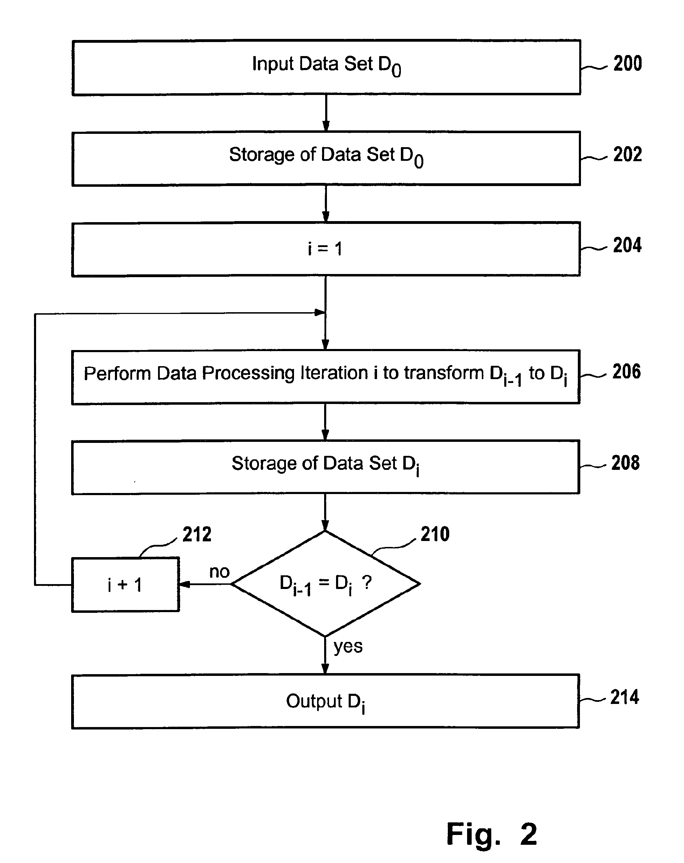

Figure 2 shows a corresponding flow chart. In step 200 data set D₀ is entered into the data processing system. In step 202 the data set D₀ is stored for the purpose of later comparison with the transformed data set.

In step 204 the index i is initialised, i.e. i = 1.

In step 206 one data processing iteration is performed in order to transfer data set Dᵢ₋₁ to data set Dᵢ. The resulting data set Dᵢ is stored in step 208. It is important to note that storage of data set Dᵢ in step 208 does not overwrite data set Dᵢ₋₁₋

In step 210 it is determined whether data sets Dᵢ₋₁ and data set Dᵢ are identical. If these data sets are not identical at least one further iteration is required and the index i is incremented in step 212 before the control goes back to step 206.

If the contrary is the case the stop criterion for the iterative data processing is met and the data set Dᵢ is outputted in step 214.

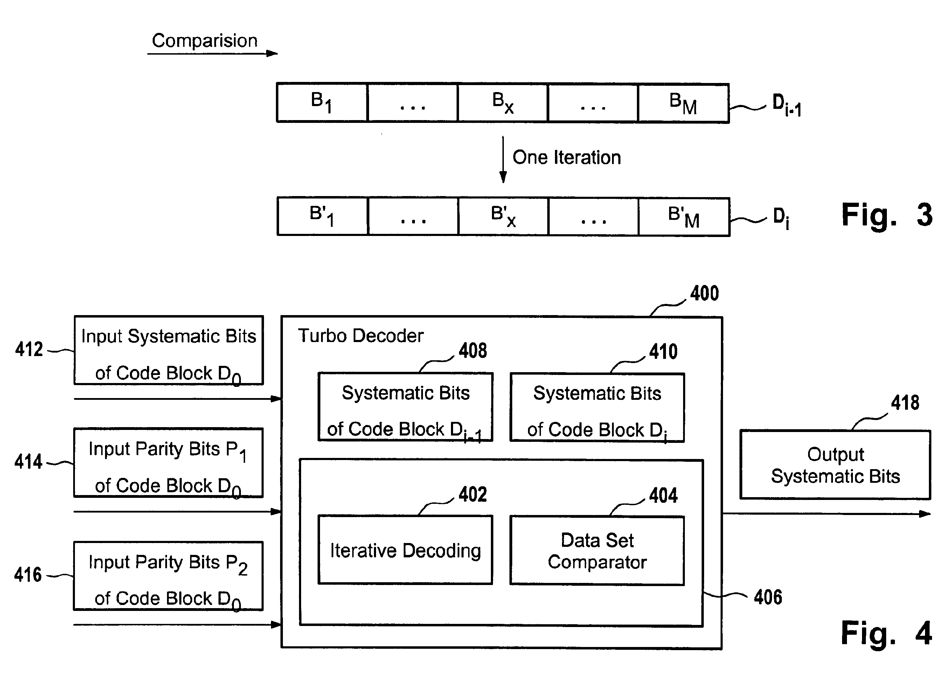

Preferably the comparison operation performed in step 210 is performed sequentially. This is illustrated in figure 3:
Figure 3 illustrates by way of example data set Dᵢ₋₁ having a number of M data bits B₁, B₂, ... B_{M}. Data set Dᵢ₋₁ is transformed to data set Dᵢ by one data processing iteration as explained above with reference to figures 1 and 2. This way the data bits B₁, B₂, ..., B_{M} of data set Dᵢ₋₁ are transformed to the same number of M data bits B'₁, B'₂,...B'_{M} of data set Dᵢ.

The comparison of the data sets Dᵢ₋₁ and Dᵢ starts with the first bits in the respective sequences, i.e. data bits B₁ and B'₁. When those two data bits are identical, the consecutive data bits in the sequence are compared, i.e. data bits B₂ and B'₂, etc.

For example, when data bits Bₓ and B'ₓ are compared it is determined, that these data bits are different. In this instance the comparison process stops and the rest of the respective data bit sequences is not compared as a deviation has already been detected. In this instance the following iteration is initiated using data set Dᵢ as an input data set.

Figure 4 shows a block diagram of a turbo decoder 400 which has processor 406 for execution of program modules 402 and 404. Program module 402 can be an implementation of a prior art turbo decoder algorithm. Program module 404 provides a data set comparator similar to data set comparator 104 of figure 1.

Further turbo decoder 400 has memory areas 408 and 410 for storing of code blocks Dᵢ₋₁ and Dᵢ, respectively.

In operation turbo decoder 400 receives data set 412 which contains the so called systematic bits of a code block D₀ . In addition turbo decoder 400 receives parity-bits data sets 414 and 416 for systematic-bits data set 412 containing input parity bits P₁ and input parity bits P₂ of code block D₀ .

Input data set 412 is stored in memory area 408 after optional hard-bit detection. Further systematic-bits data set 412 and parity-bits data sets 414, 416 are entered into program module 402 in order to perform one turbo decoding iteration. This way code block D₀ is transformed to code block D₁ and stored into memory area 410.

For the next iteration code block D₁ of memory area 410 is used as an input data set for program module 402 and the result of the transformation of code block D₁ which is code block D₂ is stored in memory area 408, etc.

Between iterations program module 404 compares the code blocks which are stored in memory areas 408 and 410. When both code blocks are identical, the stop criterion is met and the result of the previous iteration having the highest index i is outputted as decoded output dataset 418.

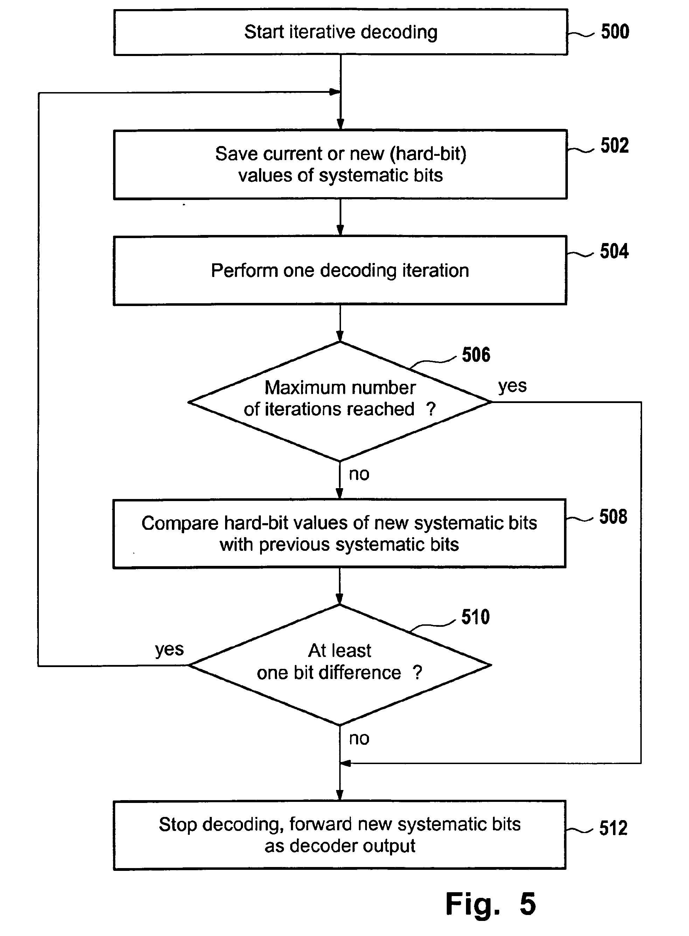

Figure 5 is illustrative of a flow chart of an embodiment for performing turbo decoding in accordance with the present invention.

In step 500 the iterative decoding is started by inputting of a code block together with its corresponding parity information. The hard-bit values of the systematic bits contained in the code block are stored in step 502. In step 504 one iteration of the turbo decoding is performed. In step 506 it is checked whether a predefined maximum number of iterations has been reached. If this is the case the control goes to step 512 and the systematic bits which have been stored in step 502 are outputted.

If the contrary is the case the hard-bit values of the new systematic bits provided by the iteration performed in step 504 are compared with the systematic bits which have been previously stored in step 502.

In step 510 it is determined whether the new systematic bits provided by the iteration of step 504 and the systematic bits which have been previously stored in step 502 differ in at least one bit position. If this is the case the control goes back to step 502 where the new systematic bits of the iteration of step 504 are saved for later reference.

If the contrary is the case the stop criterion has been met and the control goes to step 512.

It is to be noted that step 506 is not essential for the principles of the present invention. Step 506 is a security mechanism which prevents an endless loop for cases where the input dataset is so corrupted that the iterative decoding does not converge.

For example a turbo decoder operating in accordance with the principles of figure 5 can be used for the implementation of a base station of a wireless cellular mobile communication network, such as a GSM or UMTS network. In the case of a UMTS network the base station is also referred to as Node B.

### List of Reference Numerals

- 100: data processing system
- 102: program module
- 104: program module
- 106: processor
- 108: memory area
- 110: memory area
- 112: input data set
- 114: output data set
- 400: turbo decoder
- 402: program module
- 404: program module
- 406: processor
- 408: memory area
- 410: memory area
- 412: systematic-bits data set
- 414: parity-bits data set
- 416: parity-bits data set
- 418: output data set

## Claims

1. A data processing method of transforming an input data set having a number of data bits to an output data set having the same number of data bits by means of a data processing module, the data processing module being adapted to transform a first data set containing the number of data bits to a second data set containing the number of data bits in one data processing iteration, the data processing method comprising the steps of:
- entering the input data set as a first data set into the data processing module,
- performing a data processing iteration by means of the data processing module to provide the second data set,
- outputting the second data set as the output data set if the first and second data sets of the same data processing iteration are identical, and otherwise entering the second data set as a first data set for a consecutive data processing iteration.

2. The method of claim 1, further comprising performing a sequential comparison of the data bits of the first and second data sets of the same iteration and stopping of the sequential comparison if a single deviating data bit of the first and second data sets of the same duration has been identified.

3. The method of claim 1, the data processing iteration being a turbo decoding iteration.

4. The method of claim 3, the input data set containing the systematic bits of a code block and further comprising entering of first and second parity bit blocks of the code block.

5. The method of claim 1, whereby the second data set being provided by a previous data processing iteration is outputted as the output data set, if a predefined maximum number of iterations has been reached.

6. A computer program product for transforming an input data set containing a number of data bits to an output data set containing the same number of data bits by means of a data processing module, the data processing module being adapted to transform a first data set containing the number of data bits to a second data set containing the number of data bits in one data processing iteration, the computer program product comprising program means for performing the steps of:
- entering the input data set as a first data set into the data processing module,
- performing a data processing iteration by means of the data processing module to provide the second data set,
- outputting the second data set as the output data set if the first and second data sets of the same data processing iteration are identical, and otherwise entering the second data set as a first data set for a consecutive data processing iteration.

7. The computer program product of claim 6, the data processing module being adapted to perform a turbo decoding iteration, the input data set being a code block containing systematic bits.

8. A data processing system for transforming an input data set (112; 412) containing a number (M) of data bits to an output data set (114; 418) containing the same number of data bits comprising:
- a data processing module (102; 402) being adapted to transform a first data set containing the number of data bits to a second data set containing the number of data bits in one data processing iteration,
- first and second storage means (108, 110; 408; 410) for storing of the first and second data sets,
- means (104; 404) for comparing of the first and second data sets, the means for comparing the first and second data sets being adapted to stop the iterative data processing when the first and second data sets of the same iteration are identical.

9. The data processing system of claim 8, the data processing module being adapted to perform a turbo decoding iteration.

10. A base station of a cellular mobile communication network comprising:
- antenna means for receiving of code blocks,
- means (402) for turbo decoding of the code blocks, the means for turbo decoding being adapted to transform a first code block containing a number of data bits to a second code block containing the same number of data bits in one turbo decoding iteration,
- first and second means (408; 410) for storing of first and second code blocks,
- means (404) for comparing of first and second code blocks of the same iteration to provide a stop criterion for the turbo decoding.
